(19) Europäisches Patentamt
European Patent Office
Office européen des brevets

(11) Publication number: **0 054 109**
**B1**

(12) **EUROPEAN PATENT SPECIFICATION**

(45) Date of publication of patent specification: **19.06.85**

(51) Int. Cl.$^4$: **G 03 C 1/72,** G 11 B 7/00

(21) Application number: **81107291.7**

(22) Date of filing: **16.09.81**

(54) **A video storage disk and a method of preparing the same.**

(30) Priority: **15.12.80 US 216341**

(43) Date of publication of application:
**23.06.82 Bulletin 82/25**

(45) Publication of the grant of the patent:
**19.06.85 Bulletin 85/25**

(84) Designated Contracting States:
**DE FR GB IT**

(56) References cited:
**EP-A-0 020 896**
**EP-A-0 020 896**
**US-A-4 036 648**
**US-A-4 082 552**

**IBM TECHNICAL DISCLOSURE BULLETIN, vol. 22, no. 5, October 1979, pages 2119-2121, New York (USA);**

**IBM TECHNICAL DISCLOSURE BULLETIN, vol. 20, no. 7, December 1977, pages 2872-2873, New York (USA);**

(73) Proprietor: **International Business Machines Corporation**
**Old Orchard Road**
**Armonk, N.Y. 10504 (US)**

(72) Inventor: **Engler, Edward Martin**
**467 Curie Drive**
**San Jose California 95123 (US)**
Inventor: **Kaufman, Frank Benjamin**
**762 Kitchawan Road**
**Ossining New York 10546 (US)**
Inventor: **Kramer, Steven Robert**
**60A Moseman Avenue, RD 2**
**Katonah New York 10536 (US)**
Inventor: **Scott, Bruce Albert**
**10 Deerfield Lane**
**Pleasantville New York 10570 (US)**

(74) Representative: **Lewis, Alan John**
**IBM United Kingdom Patent Operations Hursley Park**
**Winchester, Hants, S021 2JN (GB)**

**EP 0 054 109 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(56) References cited:
IBM TECHNICAL DISCLOSURE BULLETIN, vol. 22, no. 5, October 1979, pages 2119-2121, New York (USA); E.M. ENGLER et al.: "High density video storage based on organic charge transfer salts"

IBM TECHNICAL DISCLOSURE BULLETIN, vol. 20, no. 7, December 1977, pages 2872-2873, New York (USA); E.M. ENGLER et al.: "Compositions for use in optically printing high conductive characters"

**Description**

This invention relates to a video storage disk and the method of preparing the same.

Present day video storage disks are used to receive optically transmitted information which can be stored in thin film layers of radiation or thermal sensitive materials. The stored information can be read by optical techniques.

Typically, these disks are comprised of a substrate having disposed thereon radiation sensitive materials such as chalcogenide glasses or polymeric films having dyes embedded therein (for a comprehensive review of optical storage media see the article entitled "Review and Analysis of Optical Recording Media", Optical Engineering, Vol. 15, No. 2, pages 99—108, 1976). In these disks the absorption of actinic radiation causes a hole or crevice to be formed in the irradiated region. These deformations are optically read. Other materials employed in video disks undergo photochromism when exposed to actinic radiation. For example, azo-based dyes in a polymer matrix are coated on a substrate. When exposed to actinic radiation these dyes undergo absorption spectrum changes which can be fixed chemically to provide optically patterned information.

U.S. specifications Nos. 4,036,648 and 4,082,552 disclose a printing material comprising a substrate having deposited thereon a photosensitive layer comprising a halocarbon and a substituted fulvalene compound having the formula

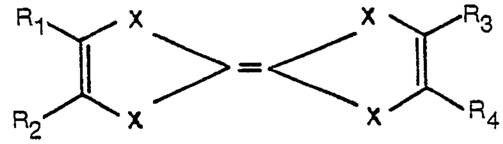

where X is oxygen, sulphur, selenium, tellurium or any combination thereof; and $R_1$, $R_2$, $R_3$, $R_4$ comprise hydrogen, alkyl groups, halogens, $SCH_3$, $CO_2$ Me, phenyl groups, substituted phenyl groups, or fused cyclics including cyclopentene, cyclohexene, benzene, furan, thiophene, dihydrofuran, dihydrothiophene and their derivatives. The layer is normally electrically non-conductive, but is sensitive to actinic radiation to form conductive areas corresponding to irradiated areas.

Examples of such compounds are tetrathiafulvalene (TTF), tetraselenafulvalene (TSeF), cis/trans dimethyl tetrathiafulavalene (ATTF), and hexa or tetra methyl tetrathiafulvalene (HMTTF or TMTTF). Examples of halocarbons are $CCl_4$, $CBr_4$, $CI_4$ and $CF_4$.

IBM Technical Disclosure Bulletin, Vol. 22, No. 5, October 1979, pages 2119 to 2122 discloses a high density, optical, video storage system. The storage medium again comprises a substituted fulvalene compound and examples described are tetrathiafulvalene (TTF), tetraselenafulvalene (TSeF) and substituted compounds thereof.

IBM Technical Disclosure Bulletin, Vol. 20, No. 7, December 1977, page 2872 describes by contrast a photosensitive layer comprising other than tetrathiofulvalene derivatives. Suitable materials are tetrathia- and tetraselenatetracenes, pyranylidene and dithiapyrany-lidene derivatives, and 3,3′-bis (1,2-dithiole) derivatives.

Although present day video storage materials, of which the foregoing compounds are examples, have proven adequate for their intended use, that is static storage and display, we have found that they have not met all the property requirements necessary for video disk applications. Materials useful as optical, video disk imaging media must have the following properties:—

1. the ability to optically receive video information;
2. the ability to store this information in high density, e.g., on the order of $10^{16}$m (1 micron) images;
3. provide high optical contrast between data images and background;
4. be capable of absorbing suitable wavelength for detection of the stored information;
5. have appropriate mechanical properties, such as being capable of strongly adhering to substrates and having uniform film forming properties; and
6. they must have long term stability of the stored video information.

It is an object of the invention to provide a high resolution optical video storage disk, the storage medium of which has the foregoing properties.

Accordingly the invention provides a high resolution optical video storage disk comprising a substrate having deposited thereon a photosensitive layer of a halocarbon and a monofunctionally substituted tetraheterofulvalene compound, said disk being characterised in that the monofunctionally substituted tetraheterofulvalene compound has the molecular structure

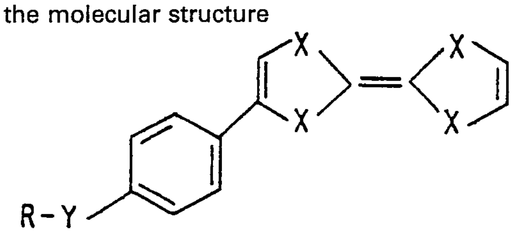

wherein

X is S or Se,

R is an alkyl group having from 1 to 8 carbon atoms, benzyl, or a benzyl group which is part of a polymer chain, and

Y is a —COO— ester or ether group, and

in that the halocarbon is present in the layer in an amount ranging from 0.05 to 0.5 times the concentration of the substituted tetraheterofulvalene compound.

The invention also provides a method for preparing high resolution video storage discs comprising depositing a photosensitive film of a halocarbon and a monofunctionally substituted tetraheterofulvalene compound on a substrate, said method being characterised in that the monofunctionally substituted tetraheterofulvalene compound has the molecular structure

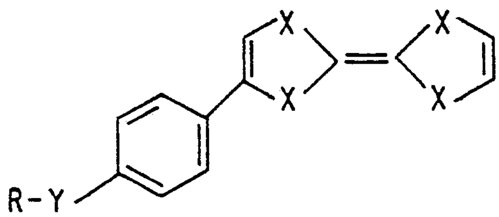

wherein

X is S or Se,

R is an alkyl group having from 1 to 8 carbon atoms, benzyl, or a benzyl group which is part of a polymer chain, and

Y is a —COO— ester or ether group, and

in that the halocarbon is present in the layer in an amount ranging from 0.05 to 0.5 times the concentration of the substituted tetraheterofulvalene compound.

Specific compounds which can be successfully used in the present invention include

p-methoxy phenyl tetrathiafulvalene
p-ethoxy phenyl tetrathiafulvalene
p-propoxy phenyl tetrathiafulvalene
p-butoxyphenyltetrathiafulvalene
p-pentoxy phenyl tetrathiafulvalene
p-hexoxy phenyl tetrathiafulvalene
p-heptoxy phenyl tetrathiafulvalene
p-octoxy phenyl tetrathiafulvalene
poly(p-methylenoxy-(p-phenyltetrathiafulvalene) styrene)
p-methoxyphenyl tetraselenafulvalene
p-ethoxy phenyl tetraselenafulvalene
p-propoxy phenyl tetraselenafulvalene
p-butoxyphenyl tetraselenafulvalene
p-pentoxy phenyl tetraselenafulvalene
p-hexoxy phenyl tetraselenafulvalene
p-heptoxy phenyl tetraselenafulvalene
p-octoxy phenyl tetraselenafulvalene
poly(p-methylenoxy-(p'-phenyl tetraselenafulvalene) styrene)
p-carbomethoxyphenyltetrathiafulvalene
p-carboethoxy phenyl tetrathiafulvalene
p-carbopropoxy phenyl tetrathiafulvalene
p-carbo butoxy phenyl tetrathiafulvalene
p-carbo pentoxy phenyl tetrathiafulvalene
p-carbo hexoxy phenyl tetrathiafulvalene
p-carbo heptoxy phenyl tetrathiafulvalene
p-carbo octoxy phenyl tetrathiafulvalene
poly(p-carboxy-(p'-phenyltetrathiafulvalene) styrene)
p-carbomethoxyphenyltetraselenafulvalene
p-carboethoxy phenyl tetraselenafulvalene
p-carbopropoxy phenyl tetraselenafulvalene
p-carbo butoxy phenyl tetraselenafulvalene
p-carbo pentoxy phenyl tetraselenafulvalene
p-carbo hexoxy phenyl tetraselenafulvalene
p-carbo heptoxy phenyl tetraselenafulvalene
p-carbo octoxy phenyl tetraselenafulvalene
poly(p-carboxy-(p'-phenyltetraselenafulvalene) styrene)

The halocarbons chosen for the purposes of this invention include those which have a high electron

affinity for photo-reactions with the above tetraheterofulvalene derivatives. Typically, they are selected from $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$, $CHBr_3$, and the like.

The halocarbon is present in the composition in amounts ranging from 0.05—0.5 times the concentration of the tetraheterofulvalene.

The sensitivity and the resolution of image development depends a great deal on the purity of the components of the composition as well as the mole ratio of the halocarbon to the tetraheterofulvalene. Typically, this mole ratio is maintained in a range of from 0.1 to 0.2

Solvents which can be used include toluene, chloroform, methylene chloride, tetrahydrofuran, methylethylketone and the like. The specific solvent used depends on the solubility characteristic of the specific tetraheterofulvalene and on the desired film thickness.

Films are generally prepared by the well known spin casting technique. However, dip coating techniques can similarly be used.

The tetraheterofulvalene derivatives can be prepared by known synthetic procedures. Typical procedures are described in the article entitled "Preparation of Tetrathiafulvalenes (TTF) and Their Selenium Analog: Tetraselenafulvalenes (TSeF)", *Synthesis* 489 (1979) and in U.S. Patent No. 4,142,783.

Suitable substrates upon which the compositions can be cast include glass, plastic, quartz, mylar (Registered Trade Mark) and the like.

Exposure of the video media disks were performed by using 200 watt Hg lamp in conjunction with a Preco contact printer (Preco is a Registered Trade Mark). The lamp output was 40 $mw/cm^2$ in the plane of the wafer. A dichroic mirror is used during exposure to absorb infrared radiation. The lamp provides radiation in the range of 3 to $5 \times 10^{17}$m (3000Å to 5000Å). The disks are exposed for times from about 10 secondes to about 120 seconds.

After exposure of the video disk in the presence of a mask an image is developed by removing the unexposed areas with a non-polar solvent. Suitable developing solvents include tetrahydrofuran, chloroform, toluene, methylethylketone, methylene chloride, and the like.

The developed images show no evidence of solvent induced distortions or loss of resolution. This is unlike the prior art video disk materials where solvent induce distortion is a serious problem.

The films show strong absorptions in the ultraviolet and visible regions of the spectrum i.e., from about $9 \times 10^{17}$m (9,000Å) to about $2 \times 10^{17}$m (2,000Å). These absorptions can be detected by a laser reading system as a means for reading the written video information on the exposed disks.

Example 1

Films are spin casted onto a substrate from a solution containing 15 mg of p-methoxyphenyltetrathiafulvalene and 1 mg ofg $CBr_4$ in about 50 µl of dry tetrahydrofuran. A film of about $10^{-6}$m (1 micron) thickness is deposited in this way.

The film is exposed through a mask with a 200 watt Hg lamp for about 20 seconds. After exposure an image was developed by immersing the film in tetrahydrofuran for about 30 seconds. The developed images absorb with a maximum at $6.5 \times 10^{-7}$m (6500Å) and possess an optical density difference of 0.8. Other absorptions at $8 \times 10^{-7}$m (8000Å) and $18 \times 10^{-7}$m (18,000Å) are also observed.

Example 2

The procedure disclosed in Example 1 was repeated except that about 50 mg of poly(p-methylenoxy-(p'-phenyltetrathiafulvalene) styrene and 5 mg of $C_2Br_2Cl_4$, dissolved in 100 µl of dry tetrahydrofuran, was spin casted onto a suitable substrate. An image was developed by immersing the exposed film in methylethyl ketone. Optical absorptions with maximum at $6.5 \times 10^{-7}$, $8 \times 10^{-7}$ and $18 \times 10^{-7}$m (6500Å, 8000Å and 18,000Å) were observed.

Example 3

The procedure of Example 1 is again repeated except that about 25 mg of p-carbomethoxyphenyltetrathiafulvalene and 2.0 mg of $CBr_4$ dissolved in 100 µl of toluene is spin casted onto a suitable substrate. An image was developed by immersing the exposed film in methylene chloride. Optical absorptions with maxima at $6.8 \times 10^{-7}$, $8 \times 10^{-7}$ and $18.5 \times 10^{-7}$m (6800Å, 8000Å and 18,500Å) were observed.

Example 4

The procedure of Example 1 is again repeated except that 10 mg of p-methoxyphenyltetraselenafulvalene and 1 mg of $C_2Br_2Cl_4$ are dissolved in 50 µl of tetrahydrofuran. An image is developed in the exposed film by immersing it in methyl ethyl ketone. Optical absorptions with maxima at $7.4 \times 10^{-7}$, $9 \times 10^{-7}$ and $18 \times 10^{-7}$m (7400Å, 9,000Å and 18,000Å) are observed.

**Claims**

1. A high resolution optical video storage disk comprising a substrate having deposited thereon a photosensitive layer of a halocarbon and a monofunctionally substituted tetraheterofulvalene compound,

said disk being characterised in that the monofunctionally substituted tetraheterofulvalene compound has the molecular structure

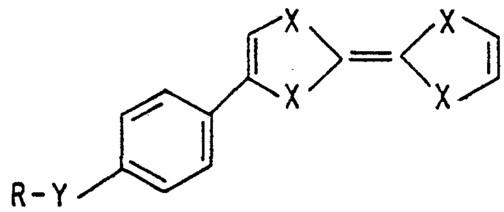

wherein

X is S or Se,

R is an alkyl group having from 1 to 8 carbon atoms, benzyl, or a benzyl group which is part of a polymer chain, and

Y is a —COO— ester or ether group, and

in that the halocarbon is present in the layer in an amount ranging from 0.05 to 0.5 times the concentration of the substituted tetraheterofulvalene compound.

2. A disk according to Claim 1, wherein said halocarbon is $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$ or $CHBr_3$.

3. A disk according to claim 2, wherein said monofunctionally substituted tetraheterofulvalene is

p-methoxy phenyl tetrathiafulvalene
p-ethoxy phenyl tetrathiafulvalene
p-propoxy phenyl tetrathiafulvalene
p-butoxyphenyltetrathiafulvalene
p-pentoxy phenyl tetrathiafulvalene
p-hexoxy phenyl tetrathiafulvalene
p-heptoxy phenyl tetrathiafulvalene
p-octoxy phenyl tetrathiafulvalene
poly(p-methylenoxy-(p-phenyltetrathiafulvalene) styrene)
p-methoxyphenyl tetraselenafulvalene
p-ethoxy phenyl tetraselenafulvalene
p-propoxy phenyl tetraselenafulvalene
p-butoxyphenyl tetraselenafulvalene
p-pentoxy phenyl tetraselenafulvalene
p-hexoxy phenyl tetraselenafulvalene
p-heptoxy phenyl tetraselenafulvalene
p-octoxy phenyl tetraselenafulvalene
poly(p-methylenoxy-(p′-phenyl tetraselenafulvalene) styrene)
p-carbomethoxyphenyltetrathiafulvalene
p-carboethoxy phenyl tetrathiafulvalene
p-carbopropoxy phenyl tetrathiafulvalene
p-carbo butoxy phenyl tetrathiafulvalene
p-carbo pentoxy phenyl tetrathiafulvalene
p-carbo hexoxy phenyl tetrathiafulvalene
p-carbo heptoxy phenyl tetrathiafulvalene
p-carbo octoxy phenyl tetrathiafulvalene
poly(p-carboxy-(p′-phenyltetrathiafulvalene) styrene)
p-carbomethoxyphenyltetraselenafulvalene
p-carboethoxy phenyl tetraselenafulvalene
p-carbopropoxy phenyl tetraselenafulvalene
p-carbo butoxy phenyl tetraselenafulvalene
p-carbo pentoxy phenyl tetraselenafulvalene
p-carbo hexoxy phenyl tetraselenafulvalene
p-carbo heptoxy phenyl tetraselenafulvalene
p-carbo octoxy phenyl tetraselenafulvalene
poly(p-carboxy-(p′-phenyltetraselenafulvalene) styrene)

4. A method for preparing high resolution video storage discs comprising depositing a photosensitive film of a halocarbon and a monofunctionally substituted tetraheterofulvalene compound on a substrate,

said method being characterised in that the monofunctionally substituted tetraheterofulvalene compound has the molecular structure

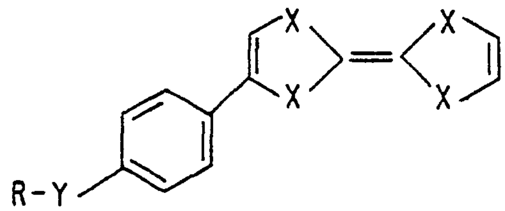

wherein

X is S or Se,

R is an alkyl group having from 1 to 8 carbon atoms, benzyl, or a benzyl group which is part of a polymer chain, and

Y is a —COO— ester or ether group, and

in that the halocarbon is present in the layer in an amount ranging from 0.05 to 0.5 times the concentration of the substituted tetraheterofulvalene compound.

5. A method according to Claim 4, wherein said halocarbon is consisting of $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$ or $CHBr_3$.

6. A method according to Claim 5, wherein said monofunctionally substituted tetraheterofulvalene is

p-methoxy phenyl tetrathiafulvalene
p-ethoxy phenyl tetrathiafulvalene
p-propoxy phenyl tetrathiafulvalene
p-butoxyphenyl tetrathiafulvalene
p-pentoxy phenyl tetrathiafulvalene
p-hexoxy phenyl tetrathiafulvalene
p-heptoxy phenyl tetrathiafulvalene
p-octoxy phenyl tetrathiafulvalene
poly(p-methylenoxy-(p-phenyltetrathiafulvalene) styrene)
p-methoxyphenyl tetraselenafulvalene
p-ethoxy phenyl tetraselenafulvalene
p-propoxy phenyl tetraselenafulvalene
p-butoxyphenyl tetraselenafulvalene
p-pentoxy phenyl tetraselenafulvalene
p-hexoxy phenyl tetraselenafulvalene
p-heptoxy phenyl tetraselenafulvalene
p-octoxy phenyl tetraselenafulvalene
poly(p-methylenoxy-(p′-phenyl tetraselenafulvalene) styrene)
p-carbomethoxy phenyl tetrathiafulvalene
p-carboethoxy phenyl tetrathiafulvalene
p-carbopropoxy phenyl tetrathiafulvalene
p-carbo butoxy phenyl tetrathiafulvalene
p-carbo pentoxy phenyl tetrathiafulvalene
p-carbo hexoxy phenyl tetrathiafulvalene
p-carbo heptoxy phenyl tetrathiafulvalene
p-carbo octoxy phenyl tetrathiafulvalene
poly(p-carboxy-(p′-phenyltetrathiafulvalene) styrene)
p-carbomethoxyphenyltetraselenafulvalene
p-carboethoxy phenyl tetraselenafulvalene
p-carbopropoxy phenyl tetraselenafulvalene
p-carbo butoxy phenyl tetraselenafulvalene
p-carbo pentoxy phenyl tetraselenafulvalene
p-carbo hexoxy phenyl tetraselenafulvalene
p-carbo heptoxy phenyl tetraselenafulvalene
p-carbo octoxy phenyl tetraselenafulvalene
poly(p-carboxy-(p′-phenyltetraselenafulvalene) styrene)

**Revendications**

1. Disque d'enregistrement vidéo optique à haute résolution comprenant un substrat sur lequel est déposée une couche photosensible d'un halocarbone et d'un composé de tétrahétérofulvalène monofonc-

tionellement substitué, ledit disque étant caractérisé en ce que le composé de tétrahétérofulvalène monofunctionnellement substitué a la structure moleculaire

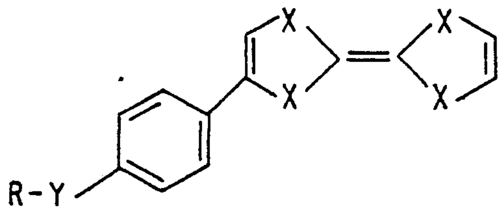

où

X représente S ou Se,

R est un groupe alcoyle en $C_1$ à $C_8$, un benzyle, ou un groupe benzyle qui est un élément d'une chaîne polymérique, et

Y est un groupe ester —COO— ou éther, et

en ce que l'halocarbone est présent dans la couche en une quantité allant de 0,05 à 0,5 fois la concentration du composé de tétrahétérofulvalène substitué.

2. Disque selon la revendication 1, où ledit halocarbone est $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$ ou $CHBr_3$.

3. Disque selon la revendication 2, où ledit tétrahétérofulvalène monofunctionnellement substitué est

p-méthoxy-phényl-tétrathiafulvalène
p-éthoxy-phényl-tétrathiafulvalène
p-propoxy-phényl-tétrathiafulvalène
p-butoxyphényltétrathiafulvalène
p-pentoxy-phényl-tétrathiafulvalène
p-hexoxy-phényl-tétrathiafulvalène
p-heptoxy-phényl-tétrathiafulvalène
p-octoxy-phényl-tétrathiafulvalène
poly(p-méthylénoxy-(p-phényltétrathiafulvalène) styrène)
p-méthoxyphényl-tétrasélénafulvalène
p-éthoxy-phényl-tétrasélénafulvalène
p-propoxy-phényl-tétrasélénafulvalène
p-butoxyphényl-tétrasélénafulvalène
p-pentoxy-phényl-tétrasélénafulvalène
p-hexoxy-phényl-tétrasélénafulvalène
p-heptoxy-phényl-tétrasélénafulvalène
p-octoxy-phényl-tétrasélénafulvalène
poly(p-méthylénoxy-(p'-phényl-tétrasélénafulvalène) styrène)
p-carbométhoxyphényltétrathiafulvalène
p-carboéthoxy-phényl-tétrathiafulvalène
p-carbopropoxy-phényl-tétrathiafulvalène
p-carbo-butoxy-phényl-tétrathiafulvalène
p-carbo-pentoxy-phényl-tétrathiafulvalène
p-carbo-hexoxy-phényl-tétrathiafulvalène
p-carbo-heptoxy-phényl-tétrathiafulvalène
p-carbo-octoxy-phényl-tétrathiafulvalène
poly(p-carboxy-(p'-phényltétrathiafulvalène) styrène)
p-carbométhoxyphényltétrasélénafulvalène
p-carboéthoxy-phényl-tétrasélénafulvalène
p-carbopropoxy-phényl-tétrasélénafulvalène
p-carbo-butoxy-phényl-tétrasélénafulvalène
p-carbo-pentoxy-phényl-tétrasélénafulvalène
p-carbo-hexoxy-phényl-tétrasélénafulvalène
p-carbo-heptoxy-phényl-tétrasélénafulvalène
p-carbo-octoxy-phényl-tétrasélénafulvalène
poly(p-carboxy-(p'-phényltétrasélénafulvalène) styrène)

4. Procédé de préparation de disques d'enregistrement vidéo à haute résolution dans lequel on dépose une pellicule photosensible d'un halocarbone et d'un composé de tétrahétérofulvalène monofunctionnellement substitué sur un substrat, ledit procédé étant caractérisé en ce que le composé de tétrahétérofulvalène monofunctionnellement substitué a la structure moléculaire

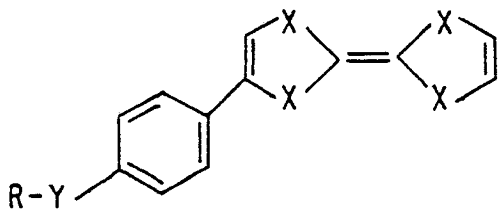

où

X représente S ou Se,

R est un groupe alcoyle en $C_1$ à $C_8$, un benzyle, ou un groupe benzyle qui est un élément d'une chaîne polymérique, et

Y est un groupe ester —COO— ou éther, et

en ce que l'halocarbone est présent dans la couche en une quantité allant de 0,05 à 0,5 fois la concentration du composé de tétrahétérofulvalène substitué.

5. Procédé selon la revendication 4, où ledit halocarbone consiste en $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$ ou $CHBr_3$.

6. Procédé selon la revendication 5, où ledit tétrahétérofulvalène monofunctionnellement substitué est

p-méthoxy-phényl-tétrathiafulvalène
p-éthoxy-phényl-tétrathiafulvalène
p-propoxy-phényl-tétrathiafulvalène
p-butoxyphényl-tétrathiafulvalène
p-pentoxy-phényl-tétrathiafulvalène
p-hexoxy-phényl-tétrathiafulvalène
p-heptoxy-phényl-tétrathiafulvalène
p-octoxy-phényl-tétrathiafulvalène
poly(p-méthylénoxy-(p-phényltétrathiafulvalène) styrène)
p-méthoxyphényl-tétrasélénafulvalène
p-éthoxy-phényl-tétrasélénafulvalène
p-propoxy-phényl-tétrasélénafulvalène
p-butoxyphényl-tétrasélénafulvalène
p-pentoxy-phényl-tétrasélénafulvalène
p-hexoxy-phényl-tétrasélénafulvalène
p-heptoxy-phényl-tétrasélénafulvalène
p-octoxy-phényl-tétrasélénafulvalène
poly(p-méthylénoxy-(p'-phényl-tétrasélénafulvalène) styrène)
p-carbométhoxyphényltétrathiafulvalène
p-carboéthoxy-phényl-tétrathiafulvalène
p-carbopropoxy-phényl-tétrathiafulvalène
p-carbo-butoxy-phényl-tétrathiafulvalène
p-carbo-pentoxy-phényl-tétrathiafulvalène
p-carbo-hexoxy-phényl-tétrathiafulvalène
p-carbo-heptoxy-phényl-tétrathiafulvalène
p-carbo-octoxy-phényl-tétrathiafulvalène
poly(p-carboxy-(p'-phényltétrathiafulvalène) styrène)
p-carbométhoxyphényltétrasélénafulvalène
p-carboéthoxy-phényl-tétrasélénafulvalène
p-carbopropoxy-phényl-tétrasélénafulvalène
p-carbo-butoxy-phényl-tétrasélénafulvalène
p-carbo-pentoxy-phényl-tétrasélénafulvalène
p-carbo-hexoxy-phényl-tétrasélénafulvalène
p-carbo-heptoxy-phényl-tétrasélénafulvalène
p-carbo-octoxy-phényl-tétrasélénafulvalène
poly(p-carboxy-(p'-phényltétrasélénafulvalène) styrène)

**Patentansprüche**

1. Hochauflösende optische Videospeicherplatte mit einem Substrat, auf welchem eine lichtempfindliche Schicht aus einem Halogenkohlenwasserstoff und einer monofunktionell substituierten

Tetraheterofulvalenverbindung abgeschieden ist, dadurch gekennzeichnet, daß die monofunktionell substituierte Tetraheterofulvalenverbindung die Molekularstruktur

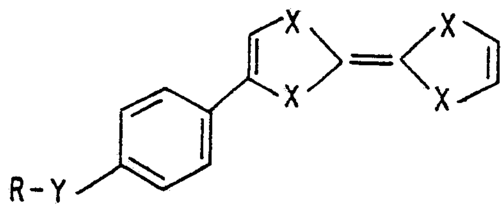

hat, wobei

X S oder Se ist,

R eine Alkylgruppe mit 1 bis 8 Kohlenstoffatomen, Benzyl, oder eine Benzylgruppe, welche Teil einer Polymerkette ist, und

Y eine —COO— Ester- oder Äthergruppe ist, und

daß der Halogenkohlenwasserstoff in der Schicht in einer Menge im Bereich zwischen dem 0,05- und dem 0,5-fachen der Konzentration der substituierten Tetraheterofulvalenverbindung vorhanden ist.

2. Platte nach Anspruch 1, bei welcher der Halogenkohlenwasserstoff $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$ oder $CHBr_3$ ist.

3. Platte nach Anspruch 2, bei welcher das monofunktionell substituierte Tetraheterofulvalen

p-Methoxyphenyltetrathiafulvalen
p-Äthoxyphenyltetrathiafulvalen
p-Propoxyphenyltetrathiafulvalen
p-Butoxyphenyltetrathiafulvalen
p-Pentoxyphenyltetrathiafulvalen
p-Hexoxyphenyltetrathiafulvalen
p-Heptoxyphenyltetrathiafulvalen
p-Octoxyphenyltetrathiafulvalen
Poly(p-methylenoxy-(p′-phenyltetrathiafulvalen)styrol)
p-Methoxyphenyltetraselenafulvalen
p-Äthoxyphenyltetraselenafulvalen
p-Propoxyphenyltetraselenafulvalen
p-Butoxyphenyltetraselenafulvalen
p-Pentoxyphenyltetraselenafulvalen
p-Hexoxyphenyltetraselenafulvalen
p-Heptoxyphenyltetraselenafulvalen
p-Octoxyphenyltetraselenafulvalen
Poly(p-methylenoxy-(p′-phenyltetraselenafulvalen)styrol)
p-Carbomethoxyphenyltetrathiafulvalen
p-Carboäthoxyphenyltetrathiafulvalen
p-Carbopropoxyphenyltetrathiafulvalen
p-Carbobutoxyphenyltetrathiafulvalen
p-Carbopentoxyphenyltetrathiafulvalen
p-Carbohexoxyphenyltetrathiafulvalen
p-Carboheptoxyphenyltetrathiafulvalen
p-Carbooctoxyphenyltetrathiafulvalen
Poly(p-carboxy-(p′-phenyltetrathiafulvalen)styrol)
p-Carbomethoxyphenyltetraselenafulvalen
p-Carboäthoxyphenyltetraselenafulvalen
p-Carbopropoxyphenyltetraselenafulvalen
p-Carbobutoxyphenyltetraselenafulvalen
p-Carbopentoxyphenyltetraselenafulvalen
p-Carbohexoxyphenyltetraselenafulvalen
p-Carboheptoxyphenyltetraselenafulvalen
p-Carbooctoxyphenyltetraselenafulvalen oder
Poly(p-carboxy-(p′-phenyltetraselenafulvalen)styrol)

ist.

4. Verfahren zur Herstellung hochauflösender Videospeicherplatten, welches das Abscheiden eines lichtempfindlichen Films aus einem Halogenkohlenwasserstoff und einer monofunktionell substituierten

Tetraheterofulvalenverbindung beinhaltet, dadurch gekennzeichnet, daß die monofunktionell substituierte Tetraheterofulvalenverbindung die Molekularstruktur

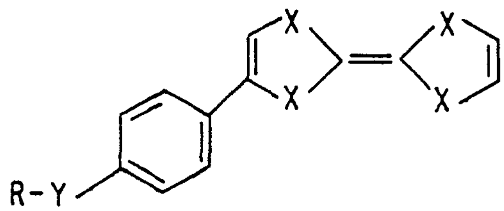

hat, wobei

X S oder Se ist,

R eine Alkylgruppe mit 1 bis 8 Kohlenstoffatomen, Benzyl, oder eine Benzylgruppe, welche Teil einer Polymerkette ist, und

Y eine —COO— Ester- oder Äther-Gruppe ist, und

daß der Halogenkohlenwasserstoff in der Schicht in einer Menge im Bereich zwischen dem 0,05- und dem 0,5-fachen der Konzentration der substituierten Tetraheterofulvalenverbindung vorhanden ist.

5. Verfahren nach Anspruch 4, bei welchem der Halogenkohlenwasserstoff aus $CCl_4$, $CBr_4$, $C_2Cl_6$, $C_2Cl_2Br_4$, $C_3Br_4H_4$, $C_2Br_2Cl_4$, $C_2H_2Cl_4$, $C_2Br_6$, $C_3Cl_8$ oder $CHBr_3$ besteht.

6. Verfahren nach Anspruch 5, bei welchem das monofunktionell substituierte Tetraheterofulvalen

p-Methoxyphenyltetrathiafulvalen
p-Äthoxyphenyltetrathiafulvalen
p-Propoxyphenyltetrathiafulvalen
p-Butoxyphenyltetrathiafulvalen
p-Pentoxyphenyltetrathiafulvalen
p-Hexoxyphenyltetrathiafulvalen
p-Heptoxyphenyltetrathiafulvalen
p-Octoxyphenyltetrathiafulvalen
Poly(p-methylenoxy-(p'-phenyltetrathiafulvalen)styrol)
p-Methoxyphenyltetraselenafulvalen
p-Äthoxyphenyltetraselenafulvalen
p-Propoxyphenyltetraselenafulvalen
p-Butoxyphenyltetraselenafulvalen
p-Pentoxyphenyltetraselenafulvalen
p-Hexoxyphenyltetraselenafulvalen
p-Heptoxyphenyltetraselenafulvalen
p-Octoxyphenyltetraselenafulvalen
Poly(p-methylenoxy-(p'-phenyltetraselenafulvalen)styrol)
p-Carbomethoxyphenyltetrathiafulvalen
p-Carboäthoxyphenyltetrathiafulvalen
p-Carbopropoxyphenyltetrathiafulvalen
p-Carbobutoxyphenyltetrathiafulvalen
p-Carbopentoxyphenyltetrathiafulvalen
p-Carbohexoxyphenyltetrathiafulvalen
p-Carboheptoxyphenyltetrathiafulvalen
p-Carbooctoxyphenyltetrathiafulvalen
Poly(p-carboxy-(p'-phenyltetrathiafulvalen)styrol)
p-Carbomethoxyphenyltetraselenafulvalen
p-Carboäthoxyphenyltetraselenafulvalen
p-Carbopropoxyphenyltetraselenafulvalen
p-Carbobutoxyphenyltetraselenafulvalen
p-Carbopentoxyphenyltetraselenafulvalen
p-Carbohexoxyphenyltetraselenafulvalen
p-Carboheptoxyphenyltetraselenafulvalen
p-Carbooctoxyphenyltetraselenafulvalen oder
Poly(p-carboxy-(p'-phenyltetraselenafulvalen)styrol)

ist.